# EUROPEAN PATENT APPLICATION

(11) **EP 4 418 327 A1**
(43) Date of publication of application: **21.08.2024**
(21) Application number: 24157344.3
(22) Date of filing: 13.02.2024
(51) Int. Cl.: H01L 29/06, H01L 29/08, H01L 29/417, H01L 29/66, H01L 29/775, H01L 29/16, H01L 29/45

(54) **INTEGRATED CIRCUIT DEVICE**

(30) Priority: 14.02.2023 KR 20230019545
(71) Applicant: Samsung Electronics Co., Ltd., Suwon-si, Gyeonggi-do 16677 (KR)
(72) Inventor: SHIN, Jongmin, 16677 Suwon-si (KR); PARK, Junmo, 16677 Suwon-si (KR); CHOI, Kyubong, 16677 Suwon-si (KR)
(74) Representative: Marks & Clerk LLP

(57) **Abstract**

An integrated circuit device may include a fin-type active structure (F1) elongated in a first horizontal direction (X), a nanosheet stack (NSS) including nanosheets on the fin-type active structure, a gate structure (160) extending between the nanosheets, a source/drain structure (130) on the fin-type active structure at a position adjacent to the gate structure and facing the nanosheet stack in the first horizontal direction, a vertical separation layer (150) including a silicon layer (151A) in contact with a silicide separation layer (151B). The silicide separation layer is between the source/drain structure and each of the nanosheet stack and the gate structure. The silicon separation layer is between the silicide separation layer and each of the nanosheet stack and the gate structure. The source/drain structure includes a metal. The gate structure includes at least one sub-gate (160S) surrounding at least one nanosheet among the plurality of nanosheets on the fin-type active structure. A bottom dielectric isolation (BDI) is under the lower surface of the gate structure.

## Description

### BACKGROUND

Inventive concepts relate to an integrated circuit device, and more particularly, to an integrated circuit device including a nanosheet structure.

As the size of integrated circuit devices decreases, the degree of integration of field effect transistors on a substrate may increase. Accordingly, a horizontal nanosheet field effect transistor (hNSFET) including a plurality of horizontal nanosheets stacked on the same layout area has been developed. Due to the increase in integration, the size of integrated circuit elements may be reduced, and contact resistance between elements and parasitic capacitance may be generated, which may affect integrated circuit performance.

### SUMMARY

Inventive concepts relate to removing or reducing the resistance and contact resistance of the source/drain structure of an integrated circuit device and/or the parasitic capacitance present in a device to improve the degree of integration and/or reliability of integrated circuit devices through the arrangement of a lower power rail.

Aspects of inventive concepts are not limited to those mentioned above, and other aspects not mentioned will be clearly understood from the description, or may be learned by practice of the presented embodiments of the present disclosure.

According to an embodiment of inventive concepts, an integrated circuit device may include a fin-type active structure elongated in a first horizontal direction; a nanosheet stack on an upper surface of the fin-type active structure, the nanosheet stack including a plurality of nanosheets spaced apart from the upper surface of the fin-type active structure at different vertical distances from the upper surface of the fin-type active structure; a gate structure on the fin-type active structure, the gate structure including at least one sub-gate surrounding at least one nanosheet among the plurality of nanosheets on the fin-type active structure, the gate structure being between each of the plurality of nanosheets and elongated in a second horizontal direction, the second horizontal direction crossing the first horizontal direction; a source/drain structure on the fin-type active structure at a position adjacent to the gate structure and the nanosheet stack in the first horizontal direction; a vertical separation layer including a silicide separation layer and a silicon separation layer in contact with the silicide separation layer, the silicide separation layer being between the source/drain structure and the nanosheet stack and between the source/drain structure and the gate structure, the silicide separation layer contacting the source/drain structure, the silicon separation layer being between the silicide separation layer and the nanosheet stack and between the silicide separation layer and the gate structure; and a bottom dielectric isolation under a lower surface of the gate structure. The source/drain structure may include a material including metal.

Each of the plurality of nanosheets in the stack is spaced apart from the upper surface of the fin-type active structure by a different amount.

The second horizontal direction may be perpendicular to the first horizontal direction.

The source/drain structure may comprise a first source/drain structure and a second source/drain structure. The first source/drain structure may be a source or a drain and the second source/drain structure may be the other of a source or a drain. In other words, if the first source/drain structure is a source, the second source/drain structure may be a drain, and if the first source/drain structure is a drain, the second source/drain structure may be a source.

In some embodiments, the integrated circuit device comprises a lower via contact contacting the lower surface of the first source/drain structure and an upper via contact contacting an upper surface of the second source/drain structure.

The vertical separation layer may separate the source/drain structure from the nanosheet stack, and be in contact with both the source/drain structure and the nanosheet stack.

In some embodiments, the intergated circuit device comprises a capping insulating pattern on the gate structure, the capping insulating pattern is on the at least one sub-gate and the nanosheet stack.

In some embodiments, the intergated circuit device comprises a capping insulating pattern on the gate structure, the capping insulating pattern is on a main gate of the gate structure.

According to an embodiment of inventive concepts, an integrated circuit device may include a fin-type active structure elongated in a first horizontal direction; a nanosheet stack on an upper surface of the fin-type active structure, the nanosheet stack including a plurality of nanosheets spaced apart from the upper surface of the fin-type active structure at different vertical distances from the upper surface of the fin-type active structure; a gate structure on the fin-type active structure, the gate structure including at least one sub-gate surrounding at least one nanosheet among the plurality of nanosheets on the fin-type active structure, the gate structure being between each of the plurality of nanosheets and elongated in a second horizontal direction, the second horizontal direction crossing the first horizontal direction; a source/drain structure including a first source/drain structure and a second source/drain structure on the fin-type active structure respectively at positions adjacent to the gate structure, the first source/drain structure and the second source/drain structure facing the nanosheet stack in the first horizontal direction, and the first source/drain structure and the second source/drain structure being among a plurality of first source/drain structures and a plurality of second source/drain structures provided alternately in the first horizontal direction on the fin-type active structure; a vertical separation layer including a silicide separation layer and a silicon separation layer in contact with the silicide separation layer, the vertical separation layer including a first vertical separation layer between the first source/drain structure and each of the nanosheet stack and the gate structure, the vertical separation layer including a second vertical separation layer between the second source/drain structure and each of the nanosheet stack and the gate structure, the silicide separation layer of the first vertical separation layer contacting the first source/drain structure and the silicide separation layer of the second vertical separation layer contacting the second source/drain structure, the silicon separation layer of the first vertical separation layer being between the silicide separation layer of the first vertical separation layer and each of the nanosheet stack and the gate structure, and the silicon separation layer of the second vertical separation layer being between the silicide separation layer of the second vertical separation layer and each of the nanosheet stack and the gate structure; and a bottom dielectric isolation in contact with a lower surface of the gate structure. The first source/drain structure and the second source/drain structure of the source/drain structure each may include a material including metal.

According to an embodiment of inventive concepts, an integrated circuit device may include a fin-type active structure elongated in a first horizontal direction; a nanosheet stack on an upper surface of the fin-type active structure, the nanosheet stack including a plurality of nanosheets spaced apart from the upper surface of the fin-type active structure at different vertical distances from the upper surface of the fin-type active structure; a gate structure on the fin-type active structure, the gate structure including at least one sub-gate surrounding at least one nanosheet among the plurality of nanosheets on the fin-type active structure, the gate structure being between each of the plurality of nanosheets and elongated in a second horizontal direction, the second horizontal direction crossing the first horizontal direction; a source/drain structure including a first source/drain structure and a second source/drain structure on the fin-type active structure respectively at positions adjacent to the gate structure, the first source/drain structure and the second source/drain structure facing the nanosheet stack in the first horizontal direction, and the first source/drain structure and the second source/drain structure being among a plurality of first source/drain structures and a plurality of second source/drain structures provided alternately in the first horizontal direction on the fin-type active structure; a vertical separation layer including a silicide separation layer and a silicon separation layer in contact with the silicide separation layer, the vertical separation layer including a first vertical separation layer between the first source/drain structure and each of the nanosheet stack and the gate structure, the vertical separation layer including a second vertical separation layer between the second source/drain structure and each of the nanosheet stack and the gate structure, the silicide separation layer of the first vertical separation layer contacting the first source/drain structure and the silicide separation layer of the second vertical separation layer contacting the second source/drain structure, the silicon separation layer of the first vertical separation layer being between the silicide separation layer of the first vertical separation layer and each of the nanosheet stack and the gate structure, and the silicon separation layer of the second vertical separation layer being between the silicide separation layer of the second vertical separation layer and each of the nanosheet stack and the gate structure; a bottom dielectric isolation contacting a lower surface of the gate structure; a lower via contact passing through at a portion of the bottom dielectric isolation, the lower via contact contacting a lower surface of the first source/drain structure; a lower power rail electrically connected to a lower portion of the lower via contact; and an upper via contact contacting an upper surface of the second source/drain structure. The bottom dielectric isolation may extend from under the gate structure to contact a lower surface of the second source/drain structure. The first source/drain structure and the second source/drain structure of the source/drain structure may include at least one of Ti, W, Ru, Nb, Mo, Hf, Ni, Co, Pt, Yb, Tb, Dy, Er, and Pd.

At least some of the above and other features of the invention are set out in the claims.

### BRIEF DESCRIPTION OF THE DRAWINGS

Embodiments will be more clearly understood from the following detailed description taken in conjunction with the accompanying drawings in which:
FIG. 1 is a plan layout diagram for explaining an integrated circuit device according to embodiments;
FIG. 2A is a cross-sectional view taken along line X1-X1' of FIG. 1 showing the integrated circuit device according to embodiments;
FIG. 2B is a cross-sectional view taken along line Y1-Y1' of FIG. 1 showing the integrated circuit device according to embodiments;
FIG. 3A is a cross-sectional view taken along line X1-X1' of FIG. 1 showing an integrated circuit device according to embodiments;
FIG. 3B is a cross-sectional view taken along line Y1-Y1' of FIG. 1 showing an integrated circuit device according to embodiments;
FIG. 4 is a cross-sectional view taken along line X1-X1' of FIG. 1 showing an integrated circuit device according to embodiments;
FIGS. 5A to 5G are diagrams illustrating a method of manufacturing an integrated circuit device according to an embodiment; and
FIGS. 6A to 6G are views illustrating a method of manufacturing an integrated circuit device according to an embodiment.

### DETAILED DESCRIPTION

Expressions such as "at least one of," when preceding a list of elements, modify the entire list of elements and do not modify the individual elements of the list. For example, "at least one of A, B, and C," and similar language (e.g., "at least one selected from the group consisting of A, B, and C") may be construed as A only, B only, C only, or any combination of two or more of A, B, and C, such as, for instance, ABC, AB, BC, and AC.

When the terms "about" or "substantially" are used in this specification in connection with a numerical value, it is intended that the associated numerical value includes a manufacturing or operational tolerance (e.g., ±10%) around the stated numerical value. Moreover, when the words "generally" and "substantially" are used in connection with geometric shapes, it is intended that precision of the geometric shape is not required but that latitude for the shape is within the scope of the disclosure. Further, regardless of whether numerical values or shapes are modified as "about" or "substantially," it will be understood that these values and shapes should be construed as including a manufacturing or operational tolerance (e.g., ±10%) around the stated numerical values or shapes. When ranges are specified, the range includes all values therebetween such as increments of 0.1%.

Hereinafter, embodiments of inventive concepts will be described in detail with reference to the accompanying drawings. The same reference numerals are used for the same components in the drawings, and duplicate descriptions thereof are omitted.

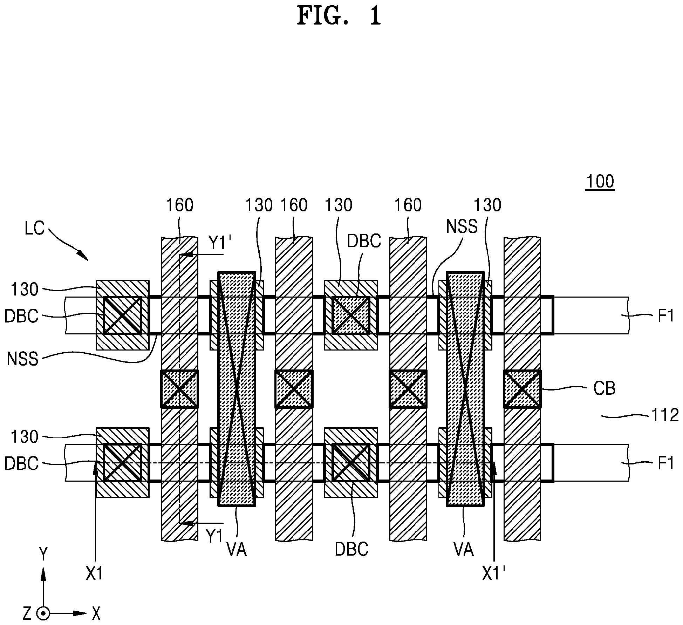

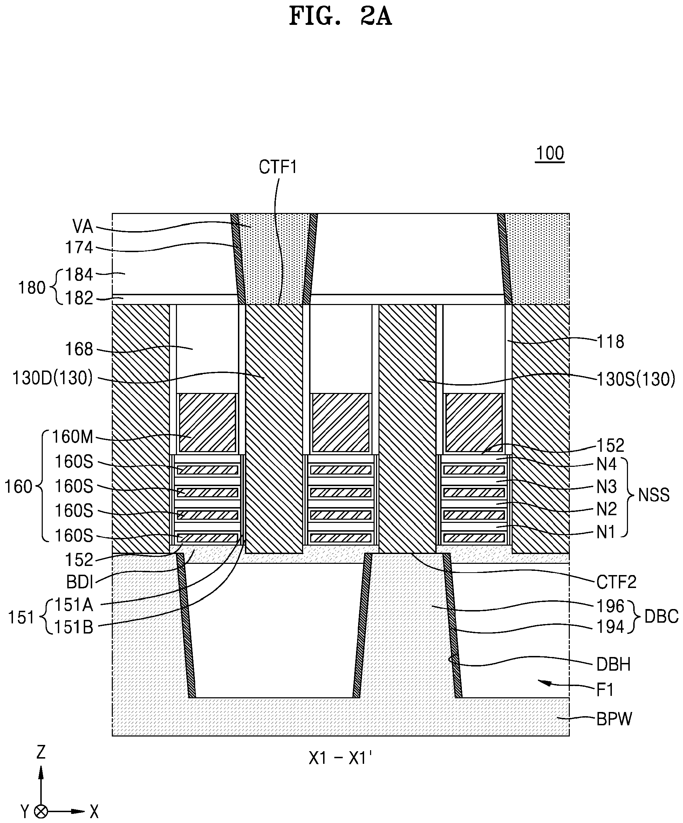

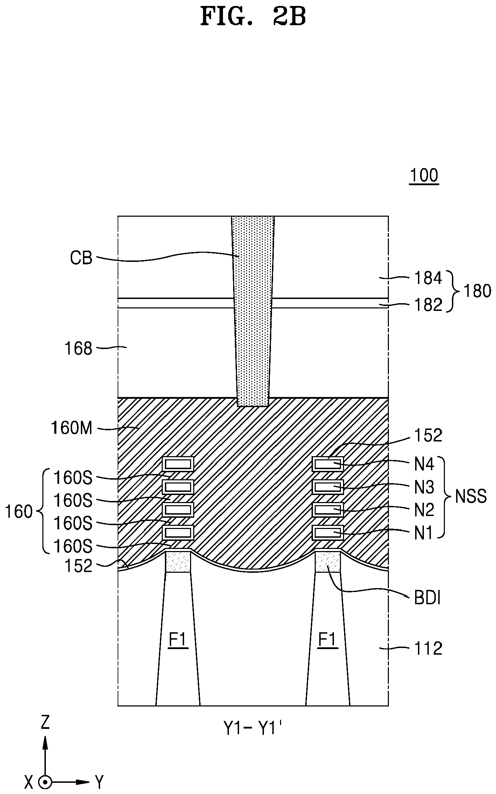

FIG. 1 is a plan layout diagram for explaining an integrated circuit device according to embodiments. FIG. 2A is a cross-sectional view taken along line X1-X1' of FIG. 1 showing an integrated circuit device 100 according to embodiments. FIG. 2B is a cross-sectional view taken along line Y1-Y1' of FIG. 1 showing an integrated circuit device 100 according to embodiments. Referring to FIGS. 1, 2A and 2B, described is the integrated circuit device 100 including a field effect transistor having a gate-all-around structure including an active region of a nanowire or nanosheet shape and a gate surrounding the active region. The integrated circuit device 100 may constitute some of logic cells LC.

Referring to FIGS. 1, 2A and 2B, the integrated circuit device 100 may include a plurality of fin-type active structures F1. The plurality of fin-type active structures F1 may extend long in the first horizontal direction (X direction) and may extend parallel to each other. The plurality of fin-type active structures F1 may include a semiconductor such as Si or Ge or a compound semiconductor such as SiGe, SiC, GaAs, InAs, InGaAs, or InP. The terms "SiGe", "SiC", "GaAs", "InAs", "InGaAs", and "InP" as used herein mean a material composed of elements included in each term, and are not a chemical formula representing a stoichiometric relationship.

A plurality of gate structures 160 may be disposed on the plurality of fin-type active structures F1. Each of the plurality of gate structures 160 may extend long in a second horizontal direction (Y direction) crossing the first horizontal direction (X direction).

A plurality of nanosheet stacks NSS may be disposed on each of the plurality of fin-type active structures F1 in structures where the plurality of fin-type active structures F1 intersect with the plurality of gate structures 160. Each of the plurality of nanosheet stacks NSS may include at least one nanosheet facing the upper surface of the fin-type active structure F1 at a position spaced apart from the upper surface of the fin-type active structure F1 in the vertical direction (Z direction). The term "nanosheet" as used in the present specification refers to a conductive structure having a cross-section substantially perpendicular to a direction in which an electric current flows. It should be understood that the nanosheets include nanowires.

As shown in FIG. 2A, the plurality of nanosheet stacks NSS may include a first nanosheet N1, a second nanosheet N2, a third nanosheet N3, and a fourth nanosheet N4 each overlapping in the mutually perpendicular direction (Z direction) on the fin-type active structure F1. The first nanosheet N1, the second nanosheet N2, the third nanosheet N3, and the fourth nanosheet N4 may have different vertical distances (Z-direction distances) from the upper surface of the fin-type active structure F1. The plurality of gate structures 160 may surround the first nanosheet N1, the second nanosheet N2, the third nanosheet N3, and the fourth nanosheet N4 included in the nanosheet stacks NSS and overlapping each other in the vertical direction (Z direction).

In FIG. 2A, a case in which the planar shape of the nanosheet stack NSS is substantially rectangular is illustrated but is not limited thereto. The nanosheet stack NSS may have various planar shapes according to the respective planar shapes of the fin-type active structure F1 and the gate structure 160. In this example, a configuration in which a plurality of nanosheet stacks NSS and a plurality of gate structures 160 are disposed on one fin-type active structure F 1, and a plurality of nanosheet stacks NSS are arranged in a row in the first horizontal direction (X direction) on one fin-type active structure F1 is provided as an example. However, the numbers of nanosheet stacks NSS and gate structures 160 disposed on one fin-type active structure F1 is not particularly limited.

Each of the first nanosheet N1, the second nanosheet N2, the third nanosheet N3, and the fourth nanosheet N4 included in the nanosheet stack NSS may function as a channel structure. In example embodiments, the first nanosheet N1, the second nanosheet N2, the third nanosheet N3, and the fourth nanosheet N4 may have substantially the same thickness in the vertical direction (Z direction). In other embodiments, at least some of the first nanosheet N1, the second nanosheet N2, the third nanosheet N3, and the fourth nanosheet N4 may have different thicknesses in the vertical direction (Z direction). In embodiments, each of the first nanosheet N1, the second nanosheet N2, the third nanosheet N3, and the fourth nanosheet N4 included in the nanosheet stack NSS may include a Si layer, a SiGe layer, or a combination thereof.

As illustrated in FIG. 2A, the first nanosheet N1, the second nanosheet N2, the third nanosheet N3, and the fourth nanosheet N4 included in one nanosheet stack NSS may have the same or similar sizes to each other in the first horizontal direction (X direction). In other embodiments, unlike that illustrated in FIG. 2A, at least some of the first nanosheets N1, second nanosheets N2, third nanosheets N3, and fourth nanosheets N4 included in one nanosheet stack NSS may have different sizes in the first horizontal direction (X direction). In this example, a case in which each of the plurality of nanosheet stacks NSS is composed of four nanosheets is provided as an example, but embodiments of inventive concepts are not limited to the illustrated example. For example, the nanosheet stack NSS may include at least one nanosheet, and the number of nanosheets constituting the nanosheet stack NSS is not particularly limited.

As illustrated in FIG. 2A, each of the plurality of gate structures 160 may include a main gate 160M and a plurality of sub-gates 160S. The main gate 160M covers the upper surface of the nanosheet stack NSS and may extend long in the second horizontal direction (Y direction). The plurality of sub-gates 160S are integrally connected to the main gate 160M and may be disposed one by one between the first nanosheet N1, the second nanosheet N2, the third nanosheet N3, and the fourth nanosheet N4, and between the first nanosheet N1 and the fin-type active structure F1. In the vertical direction (Z direction), the thickness of each of the plurality of sub-gates 160S may be less than that of the main gate 160M.

Unlike illustrated in FIG. 2A, the gate structure 160 may not include the main gate 160M. Since the vertical thickness of the gate structure 160 without the main gate 160M is less than the vertical thickness of the gate structure 160 including the main gate 160M, overlap capacitance generated in the gate structure 160 may be reduced.

Each of the plurality of gate structures 160 may be made of metal, metal nitride, metal carbide, or a combination thereof. The metal may be selected from Ti, W, Ru, Nb, Mo, Hf, Ni, Co, Pt, Yb, Tb, Dy, Er, and Pd. The metal nitride may be selected from TiN and TaN. The metal carbide may be TiAlC. However, the materials constituting the plurality of gate structures 160 are not limited to those examples above.

A gate dielectric film 152 may be disposed between the nanosheet stack NSS and the gate structure 160. In addition, a gate dielectric film 152 may be disposed between the nanosheet stack NSS and a source/drain structure 130 to be described below. In example embodiments, the gate dielectric film 152 may include a stacked structure of an interface dielectric film and a high dielectric film. The interface dielectric film may include a low-k material film having a dielectric constant of about 9 or less, for example, a silicon oxide film, a silicon oxynitride film, or a combination thereof. In example embodiments, the interface dielectric film may be omitted. The high dielectric film may be made of a material having a higher dielectric constant than the silicon oxide film. For example, the high dielectric film may have a dielectric constant of about 10 to about 25. The high dielectric film may be made of hafnium oxide but is not limited thereto.

As illustrated in FIG. 2A, the integrated circuit device 100 may include a bottom dielectric isolation BDI covering upper surfaces of each of the plurality of fin-type active structures F1. The bottom dielectric isolation BDI may be disposed between the upper surface of each of the plurality of fin-type active structures F1 and the plurality of gate structures 160 and may be in contact with the upper surface of each of the plurality of fin-type active structures F1.

The bottom dielectric isolation BDI may be under the sub-gate 160S. A portion of an upper surface of the bottom dielectric isolation BDI may be in contact with the lower end of at least a portion of the first source/drain structure 130S and the second source/drain structure 130D, as described below. The bottom dielectric isolation BDI may be in contact with portions of the lower ends of the first source/drain structure 130S and the second source/drain structure 130D while surrounding the portions. The bottom dielectric isolation BDI may surround at least a portion of an upper end and a periphery of the lower via contact 196 to be described below. In this specification, the first source/drain structure 130S may correspond to a source of a transistor and the second source/drain structure 130D may correspond to a drain of a transistor, but inventive concepts is not limited thereto.

A plurality of source/drain structures 130 may be disposed on the bottom dielectric isolation BDI on the plurality of fin-type active structures F1. The plurality of source/drain structures 130 may include a plurality of first source/drain structures 130S and a plurality of second source/drain structures 130D. At least one source/drain structure 130 among the plurality of source/drain structures 130 may have a lower surface in contact with the bottom dielectric isolation BDI. Each of the plurality of source/drain structures 130 may be disposed adjacent to at least one gate structure 160 selected from among the plurality of gate structures 160. The plurality of source/drain structures 130 may have surfaces facing the first nanosheet N1, the second nanosheet N2, the third nanosheet N3, and the fourth nanosheet N4 included in the adjacent nanosheet stack NSS, respectively. The plurality of source/drain structures 130 may contact the first nanosheet N1, the second nanosheet N2, the third nanosheet N3, and the fourth nanosheet N4 included in an adjacent nanosheet stack NSS, respectively.

Each of the plurality of source/drain structures 130 may be made of metal. The plurality of source/drain structures 130 may be formed using Physical Vapor Deposition (PVD), Chemical Vapor Deposition (CVD), or Atomic Layer Deposition (ALD) and be formed of a metal including at least one of Ti, W, Ru, Nb, Mo, Hf, Ni, Co, Pt, Yb, Tb, Dy, Er, and Pd. When the source/drain structures 130 are made of metal, they have high electrical conductivity. Thus, contact resistance of the source/drain structure 130 may be greatly reduced. In addition, since the source/drain structures 130 are formed of metal, contact resistance generated at the first contact surface CTF1 and the second contact surface CTF2, that is, surfaces where an upper via contact VA and a lower source/drain contact DBC, as described below, are in contact with the source/drain structure 130 made of metal, may be reduced.

As illustrated in FIG. 2B, a device isolation film 112 covering sidewalls of each of the plurality of fin-type active structures F1 may be disposed in a space between the plurality of fin-type active structures F1.

In example embodiments, the device isolation film 112 may include a silicon oxide film, a silicon nitride film, a silicon carbide film, a low dielectric film, or a combination thereof. The low dielectric film may be made of fluorine-doped silicon oxide, organosilicate glass, carbon-doped oxide, porous silicon oxide, porous organosilicate glass, spin-on organic polymeric dielectric, a spin-on silicon based polymeric dielectric, or a combination thereof but is not limited to the above example.

As illustrated in FIG. 2A, upper surfaces of each of the gate dielectric film 152 and the gate structure 160 may be covered with a capping insulating pattern 168. The capping insulating pattern 168 may include a silicon nitride film.

Both sidewalls of each of the gate structure 160 and the capping insulating pattern 168 may be covered with an outer insulating spacer 118. The outer insulating spacer 118 may cover both sidewalls of the main gate 160M on top of the plurality of nanosheet stacks NSS. The outer insulating spacer 118 may be spaced apart from the gate structure 160 with the gate dielectric film 152 disposed therebetween.

Both sidewalls of each of the plurality of sub-gates 160S included in the plurality of gate structures 160 may be spaced apart from the source/drain structure 130 with the gate dielectric film 152 disposed therebetween. The gate dielectric film 152 may be disposed between the sub-gate 160S and each of the first nanosheet N1, second nanosheet N2, third nanosheet N3, and fourth nanosheet N4 included in the gate structure 160. The gate dielectric film 152 may be disposed between the sub-gate 160S included in the gate structure 160 and the source/drain structure 130.

A vertical separation layer 151 may be provided between the gate structure 160 and the nanosheet stack NSS and the source/drain structure 130. The vertical separation layer 151 may be made of a material including silicon (Si). The vertical separation layer 151 may include a silicon separation layer 151A and a silicide separation layer 151B formed through epitaxial growth, as described below. The silicide separation layer 151B may contact the source/drain structure 130, and the silicon separation layer 151A may be disposed between the silicide separation layer 151B and the gate dielectric film 152. In other words, the silicon separation layer 151A may be in contact with the silicide separation layer 151B and may be disposed between the silicide separation layer 151B and the nanosheet stack NSS and the gate structure 160.

Since the vertical length of the silicide separation layer 151B is the same or substantially the same as the vertical length of the silicon separation layer 151A, a vertical length of the vertical separation layer 151 may be the same or substantially the same as a vertical length of the silicide separation layer 151B and a vertical length of the silicon separation layer 151A. The silicide separation layer 151B may be disposed between the silicon separation layer 151A and the source/drain structure 130, and the silicide separation layer 151B may be provided so that the silicon separation layer 151A and the source/drain structure 130 do not directly contact each other.

Among the vertical separation layers 151, the silicon separation layer 151A may be formed of a material including a metal silicide, a metal germanide, a metal gallide, or a metal aluminide together with an n-type dopant or a p-type dopant. A metal gallide also may be referred to as a metal galliumide (e.g., titanium galliumide, nickel galliumide, cobalt galliumide, tantalum galliumide, and tungsten galliumide).

When the silicon separation layer 151A is n-type for use with an n-type semiconductor device, the silicide separation layer 151B may include titanium silicide, nickel silicide, cobalt silicide, tantalum silicide, tungsten silicide, titanium gallium silicide, nickel gallide, cobalt gallide, tantalum gallide, and tungsten gallide in addition to phosphorus (P) or arsenic (As) as an n-type dopant.

When the silicon separation layer 151A is p-type for use with a p-type semiconductor device, the silicide separation layer 151B may include titanium silicide, nickel silicide, cobalt silicide, tantalum silicide, tungsten silicide, titanium germanide, nickel germanide, cobalt germanide, tantalum germanide, and tungsten germanide in addition to boron (B) or aluminum (Al) as a p-type dopant.

The vertical separation layer 151 may be provided on both sides of the plurality of sub-gates 160S disposed between the source/drain structures 130 and the nanosheet stack NSS in the first horizontal direction (X direction). The vertical direction (Z direction) length of the vertical separation layer 151 may be greater than the vertical level difference between the lowermost end of the plurality of sub-gates 160S disposed between the source/drain structures 130 and the uppermost end of the nanosheet stack NSS. Expressed differently, the vertical level at the lower end of the vertical separation layer 151 may be the same as the vertical level at the lower end of the source/drain structure 130 and the vertical level at the upper end of the vertical separation layer 151 may be higher than a vertical level of the upper end of the nanosheet stack NSS.

The plurality of nanosheet stacks NSS may be disposed on the plurality of fin-type active structures F1 in regions where the plurality of fin-type active structures F1 intersect with the plurality of gate structures 160 and may face the upper surface of the fin-type active structure F1 at a position spaced apart from the fin-type active structure F1. A plurality of nanosheet transistors may be formed at portions where the plurality of fin-type active structures F1 intersect with the plurality of gate structures 160.

As illustrated in FIG. 2A, a plurality of upper via contacts VA may be disposed on the plurality of source/drain structures 130. Each of the plurality of upper via contacts VA may pass through the upper insulating structure 180 and contact an upper end of at least one of the plurality of source/drain structures 130. That is, at least one of the plurality of source/drain structures 130 may be electrically connected to the upper via contact VA. A lower surface of each of the plurality of upper via contacts VA may contact the upper surface of the source/drain structure 130. A contact surface formed by contacting the lower surface of each of the plurality of upper via contacts VA and the upper surface of the source/drain structure 130 may be referred to as a first contact surface CTF1. As an embodiment, an upper via contact VA may contact an upper end of the second source/drain structure 130D.

An upper insulating liner 174 may be disposed between the upper insulating structure 180 and the upper via contact VA. The upper insulating liner 174 may be provided to surround the upper via contact VA. In example embodiments, the insulating liner 142 may be made of silicon nitride, SiCN, SiBN, SiON, SiOCN, SiBCN, or a combination thereof but is not limited thereto. The terms "SiCN", "SiBN", "SiON", "SiOCN", "SiBCN", and "SiOC" as used herein refer to a material composed of elements included in each term, and are not a chemical formula representing a stoichiometric relationship.

The plurality of upper via contacts VA may be made of a material including at least one of Ti, W, Ru, Nb, Mo, Hf, Ni, Co, Pt, Yb, Tb, Dy, Er, and Pd. As an embodiment, the plurality of upper via contacts VA may be made of a material including at least one of molybdenum (Mo) and tungsten (W) but are not limited thereto.

A plurality of backside source/drain contacts DBC may be disposed on the backside side opposite to the frontside side on which the plurality of upper via contacts VA are disposed with the plurality of source/drain structures 130 therebetween. A plurality of backside source/drain contacts DBC may be configured to be electrically connected to another part of the source/drain structure 130, which is selected from among the plurality of source/drain structures 130 and to which the frontside upper via contact VA is not connected. A contact surface formed by contacting the lower surface of each of the plurality of lower source/drain contacts DBC with the lower surface of the source/drain structure 130 may be referred to as a second contact surface CTF2. As an embodiment, a plurality of backside source/drain contacts DBC may be electrically connected to the first source/drain structures 130S, respectively, and a plurality of upper via contacts VA may be electrically connected to the second source/drain structures 130D. In an embodiment, the length of the source/drain structure 130 in the vertical direction may be equal to or less than the difference between the vertical level of the first contact surface CTF1 and the vertical level of the second contact surface CTF2.

Each of the plurality of backside source/drain contacts DBC may pass through one fin-type active structure F1 selected from among the plurality of fin-type active structures F1 in the vertical direction (Z direction). That is, in the plurality of source/drain structures 130, the source/drain structure 130 to which the upper via contact VA is connected and the source/drain structure 130 to which the backside source/drain contact DBC is connected may be spaced apart in the horizontal direction, for example, the first horizontal direction (X direction) or the second horizontal direction (Y direction).

The plurality of backside source/drain contacts DBC may have a fin-type active structure F1 through which the backside source/drain contact DBC penetrates in the vertical direction Z and sidewalls facing each of the device isolation films 112 adjacent to the fin-type active structure F1.

As illustrated in FIG. 2A, the backside source/drain contact DBC may fill the contact space DBH formed through the fin-type active structure F1. The source/drain structure 130 to which the backside source/drain contact DBC is connected may be disposed at a position overlapping the contact space DBH in the vertical direction (Z direction) on the fin-type active structure F1.

The farther away the backside source/drain contact DBC is from the source/drain structure 130 and the frontside source/drain via contact VA in the vertical direction (Z direction), widths of in the first horizontal direction (X direction) and the second horizontal direction (Y direction) may gradually increase. The farther away the frontside upper via contact VA is from the source/drain structure 130 and the backside source/drain contact DBC in the vertical direction (Z direction), widths in the first horizontal direction (X direction) and the second horizontal direction (Y direction) may gradually increase. In other words, a width of the backside source/drain contact DBC may increase as a distance of the backside source/drain contact DBC from the source/drain structure 130 increases in the vertical direction. A width of the frontside upper via contact VA may increase as a distance of the frontside upper via contact VA from the source/drain structure 130 increases in the vertical direction.

As illustrated in FIG. 2A, among the plurality of source/drain structures 130, the lower surface of the source/drain structure 130 to which the frontside upper via contact VA is connected may be in contact with the bottom dielectric isolation BDI. The source/drain structure 130 to which the frontside upper via contact VA is connected may be spaced apart from the fin-type active structure F1 in the vertical direction (Z direction) with the bottom dielectric isolation BDI therebetween. In other embodiments, unlike illustrated in FIG. 2A, the source/drain structure 130 to which the front side upper via contact VA is connected may penetrate the bottom dielectric isolation BDI in the vertical direction (Z direction) and contact the fin-type active structure F1.

A portion of an upper circumference of the source/drain structure 130 to which the backside source/drain contact DBC is connected may contact the bottom dielectric isolation BDI. As shown in FIG. 2A, all lower surfaces of the source/drain structure 130 may contact the backside source/drain contact DBC. Accordingly, the lower surface of the source/drain structure 130 to which the backside source/drain contact DBC is connected may not contact the bottom dielectric isolation BDI. That is, the upper surface of the backside source/drain contact DBC facing the source/drain structure 130 may contact the lower surface of the source/drain structure 130 and the bottom dielectric isolation BDI.

Alternatively, unlike in FIG. 2A, the backside source/drain contact DBC may contact a part of the lower surface of the source/drain structure 130. Accordingly, the bottom dielectric isolation BDI may contact a portion where the backside source/drain contact DBC does not contact the lower surface of the source/drain structure 130. That is, an upper surface of the backside source/drain contact DBC facing the source/drain structure 130 may contact a lower surface of the source/drain structure 130.

The backside source/drain contact DBC may be provided to contact the lower power rail BPW and the lower end of the source/drain structure 130 in the contact space DBH, respectively. The lower insulating liner 194 may be disposed between the lower via contact 196 and the fin-type active structure F1. The lower insulating liner 194 may be disposed between the bottom dielectric isolation BDI and the lower via contact 196. A description of a constituent material of the lower insulating liner 194 is substantially similar to that of the upper insulating liner 174.

The backside source/drain contact DBC may be disposed at a position overlapping the source/drain structure 130 in the vertical direction (Z direction) in the contact space DBH and may extend long in the vertical direction (Z direction) in the contact space DBH.

As illustrated in FIG. 2A, the bottom dielectric isolation BDI may include a portion facing a sidewall of the backside source/drain contact DBC with a portion of the lower insulation liner 194 therebetween in the first horizontal direction (X direction). In other embodiments, the insulating spacer 190 may not be disposed between the bottom dielectric isolation BDI and the sidewall of the backside source/drain contact DBC, and the bottom dielectric isolation BDI may be in contact with a sidewall of the backside source/drain contact DBC.

As illustrated in FIG. 2A, the lower power rail BPW may be connected to an end farthest from the source/drain structure 130 of the backside source/drain contact DBC. The lower power rail BPW may be disposed below the fin-type active structure F1 and electrically connected to the backside source/drain contact DBC. The lower power rail BPW may be made of a material including metal.

As illustrated in FIG. 2A, upper surfaces of each of the plurality of source/drain structures 130, the plurality of capping insulating patterns 168, and the outer insulating spacer 118 may be covered with an upper insulating structure 180. The upper insulating structure 180 may include an etch stop film 182 and an upper insulating film 184 sequentially stacked on each of the plurality of source/drain structures 130, the plurality of capping insulating patterns 168, and the outer insulating spacer 118. The etch stop film 182 may be formed of silicon carbide (SiC), SiN, nitrogen-doped silicon carbide (SiC:N), SiOC, AlN, AlON, AlO, AlOC, or a combination thereof. The upper insulating film 184 may include an oxide film, a nitride film, an ultra low-k (ULK) film having an ultra low dielectric constant K of about 2.2 to about 2.4, or a combination thereof. For example, the upper insulating film 184 may include a tetraethylorthosilicate (TEOS) film, a high density plasma (HDP) oxide film, a boro-phosphosilicate glass (BPSG) film, a flowable chemical vapor deposition (FCVD) oxide film, a SiON film, a SiN film, a SiOC film, a SiCOH film, or a combination thereof but is not limited thereto.

As illustrated in FIG. 1, a gate contact CB may be disposed on the gate structure 160. Referring to FIG. 1 and FIG. 2A, The gate contact CB may pass through the upper insulating structure 180 and the capping insulating pattern 168 in the vertical direction (Z direction) and may be connected to the gate structure 160. A lower surface of the gate contact CB may contact an upper surface of the gate structure 160. The gate contact CB may include a contact plug made of molybdenum (Mo), copper (Cu), tungsten (W), cobalt (Co), ruthenium (Ru), manganese (Mn), titanium (Ti), tantalum (Ta), aluminum (Al), a combination thereof, or an alloy thereof, but the constituent materials of the contact plug are not limited to those examples above. In example embodiments, the gate contact CB may further include a conductive barrier pattern surrounding a portion of the contact plug. The conductive barrier pattern included in the gate contact CB may be made of metal or metal nitride. For example, the conductive barrier pattern may be made of Ti, Ta, W, TiN, TaN, WN, WCN, TiSiN, TaSiN, WSiN, or a combination thereof but is not limited thereto.

As described with reference to FIG. 2A, in the integrated circuit device 100, some of the source/drain structures 130 among the plurality of source/drain structures 130 disposed on the plurality of fin-type active structures F1 may be connected to the backside source/drain contact DBC, and some of the other source/drain structures 130 among the plurality of source/drain structures 130 may be connected to the front side upper via contact VA. As an embodiment, in the integrated circuit device 100, the first source/drain structure 130S may be connected to the backside source/drain contact DBC, and the second source/drain structure 130D may be connected to the front side upper via contact VA.

In addition, since the integrated circuit device 100 of inventive concepts has a source/drain structure 130 made of metal, the source/drain structure 130 may directly contact and be electrically connected to the frontside upper via contact VA or the backside source/drain contact DBC. Accordingly, since the contact resistance at the first contact surface CTF1 and the second contact surface CTF2 is reduced, performance of the integrated circuit device 100 may be improved.

Since the source/drain structure 130 is not composed of a material including silicon but is composed of and/or includes metal, the integrated circuit device 100 according to an embodiment may include a bottom dielectric isolation BDI together with a source/drain structure 130 made of metal. Accordingly, parasitic capacitance generated under the gate structure 160 between the source/drain may be prevented or reduced through the bottom dielectric isolation BDI.

Source/drain structures in typical integrated circuit devices are formed through epitaxial growth. A source/drain structure formed through epitaxial growth may inevitably be accompanied by a bridge when formed above a certain height. In the integrated circuit device 100, which is an embodiment, since the source/drain structure 130 is made of a conductive metal, a bridge that occurs in a source/drain structure in a typical integrated circuit device does not occur.

In addition, in the integrated circuit device 100, by securing a sufficient insulation distance between each of the plurality of backside source/drain contacts DBC and the plurality of frontside upper via contacts VA, parasitic capacitance that may occur in integrated circuit devices may be limited and/or suppressed. Therefore, a stable and optimized wiring structure may be realized even within a reduced area according to down-scaling through the integrated circuit device 100, which is an embodiment, so that through this, the integration and reliability of the integrated circuit device 100 may be improved.

That is, since the above effects may be implemented simultaneously through the source/drain structure 130 made of a conductive metal, a plurality of backside source/drain contacts DBC electrically connected to the source/drain structure 130, and a plurality of frontside upper via contacts VA, the performance and reliability of the integrated circuit device 100 according to an embodiment may be improved.

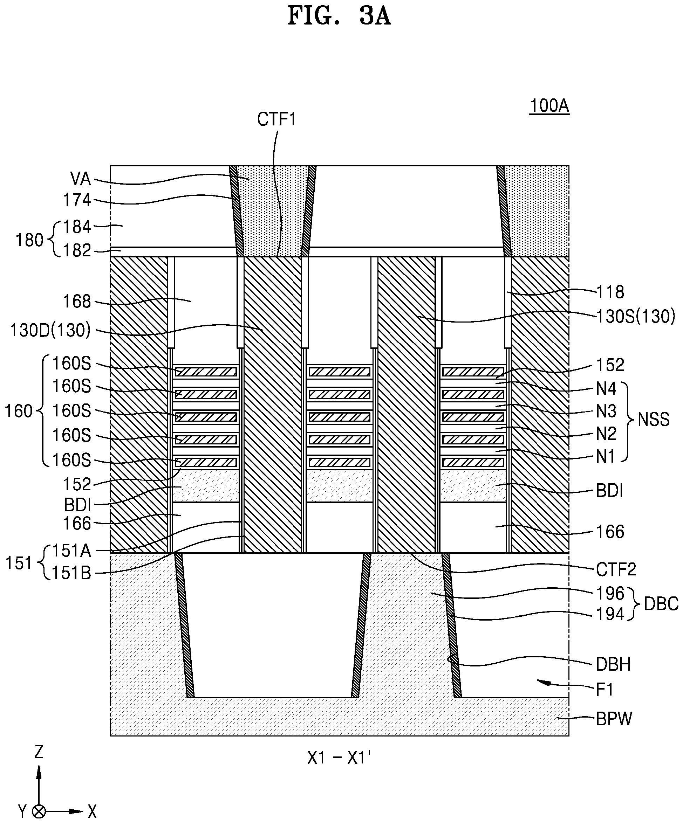

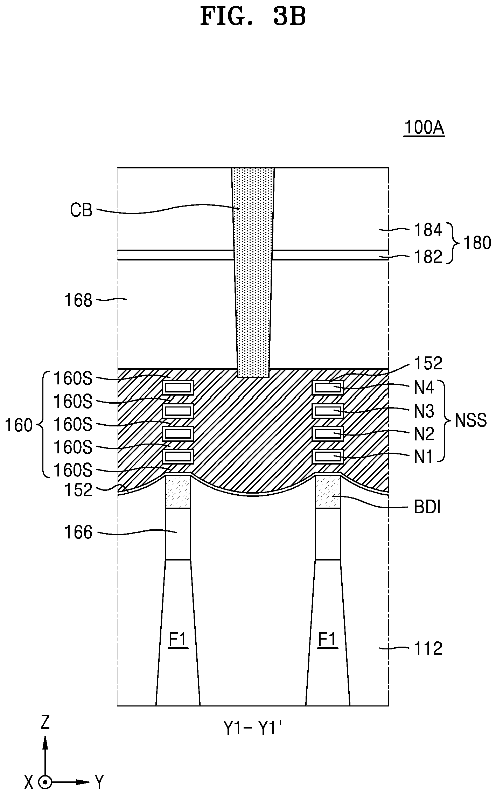

FIG. 3A is a cross-sectional view taken along line X1-X1' of FIG. 1 showing an integrated circuit device 100A according to embodiments. FIG. 3B is a cross-sectional view taken along line Y1-Y1' of FIG. 1 showing an integrated circuit device 100A according to embodiments. Description that is the same or substantially the same as that given above may be omitted.

Vertical lengths of the plurality of source/drain structures 130 may be substantially the same. A plurality of source/drain structures 130 may be provided through the bottom dielectric isolation BDI. Unlike the integrated circuit device 100 described above, in the integrated circuit device 100A, which is another embodiment, the gate structure 160 may not include the main gate 160M. A capping insulating pattern 168 may be directly disposed on the sub-gate 160S. The capping insulating pattern 168 may include a silicon nitride film.

Both sidewalls of each capping insulating pattern 168 may be covered with an outer insulating spacer 118. The outer insulating spacer 118 may cover both sidewalls of the capping insulating pattern 168 on upper surfaces of the plurality of nanosheet stacks NSS and the plurality of sub-gates 160S.

A lower insulating layer 166 may be provided between each source/drain structure 130 and under a bottom dielectric isolation BDI. At least a portion of the lower surface of the lower insulating layer 166 may contact the fin-type active structure F1 or may contact a portion of the upper surface of the lower via contact 196. A vertical level of a lower surface of the lower insulating layer 166 may be the same as a vertical level of a lower end of the source/drain structure 130.

Since a main gate is not provided in all gate structures 160 between the source/drain structures 130, the vertical height of the gate structure 160 including the plurality of sub-gates 160S may be the same or substantially the same as the vertical height of the gate structure 160 between the other source/drain structures 130. That is, the vertical height of the gate structure 160 between the source/drain structures 130 may be constant.

A vertical separation layer 151 may be disposed with a certain thickness between the plurality of sub-gates 160S, the bottom dielectric isolation BDI, and the lower insulating layer 166, and the source/drain structure 130 adjacent to the plurality of sub-gates 160S. The lower end of the vertical separation layer 151 may be at the same vertical level as the lower end of the source/drain structure 130. The upper end of the vertical separation layer 151 may be higher than the sub-gate 160S that is uppermost among the plurality of sub-gates 160S. That is, side surfaces of the source/drain structure 130 may contact the capping insulating pattern 168 and the vertical separation layer 151.

In addition to the aspects of the integrated circuit device 100, which is another embodiment described above, in the integrated circuit device 100A, which is an embodiment, the distance between the gate structure 160 and the upper via contact VA is greater than the distance between the gate structure 160 and the upper via contact VA in the integrated circuit device 100, which is another embodiment, so that the possibility of short circuiting may be reduced and/or prevented.

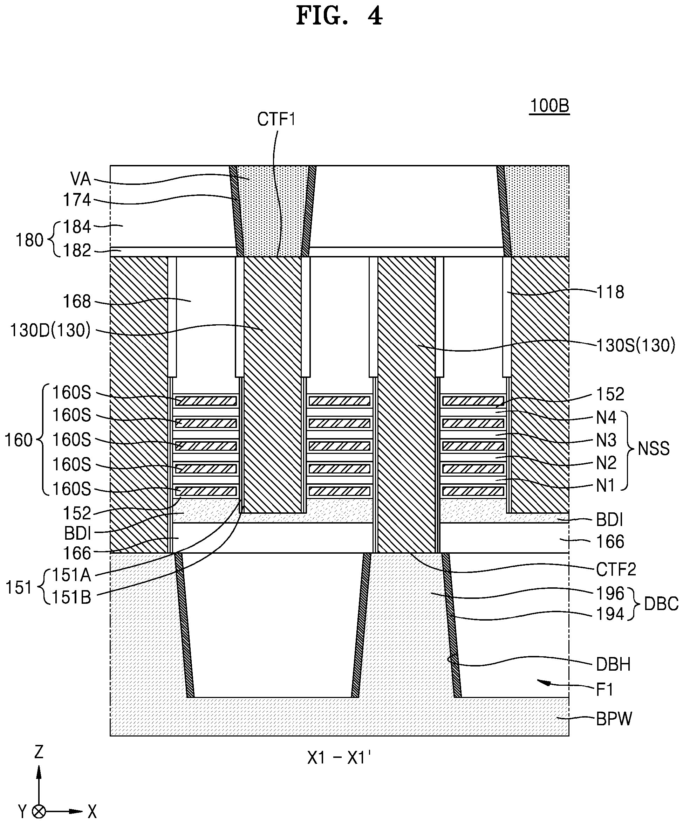

FIG. 4 is a cross-sectional view taken along line X1-X1' of FIG. 1 showing an integrated circuit device 100B according to embodiments. Description that is the same or substantially the same as that given above may be omitted.

Unlike the integrated circuit device 100A, which is an embodiment described above, some source/drain structures 130 may be provided without passing through the bottom dielectric isolation BDI. That is, the lower surface of the source/drain structure 130 that does not pass through the bottom dielectric isolation BDI contacts the bottom dielectric isolation BDI. The lower insulating layer 166 may be provided in contact with a lower surface of the bottom dielectric isolation BDI, and at least a part of the lower surface of the lower insulating layer 166 may contact the upper surface of the fin-type active structure F1.

The vertical separation layer 151 may be disposed with a certain thickness between the plurality of sub-gates 160S, the bottom dielectric isolation BDI, and the lower insulating layer 166, and the source/drain structure 130 adjacent to the plurality of sub-gates 160S. The length in the vertical direction (Z direction) of the vertical separation layer 151 contacting the portion of the source/drain structure 130 that does not penetrate the bottom dielectric isolation BDI may be shorter than the vertical length of the vertical separation layer 151 contacting the remaining source/drain structures 130 passing through the bottom dielectric isolation BDI. However, the vertical levels of the upper ends of the vertical separation layer 151 may be substantially the same. The vertical level of the upper end of the vertical separation layer 151 may be higher than the vertical level of the uppermost sub-gate 160S among the plurality of sub-gates 160S.

The vertical separation layer 151 may be divided into a first vertical separation layer disposed adjacent to the first source/drain structure 130S and a second vertical separation layer disposed adjacent to the second source/drain structure 130D. The first vertical separation layer may be disposed between the plurality of sub-gates 160S, the nanosheet stack NSS, the lower insulating layer 166, and the bottom dielectric isolation BDI and the first source/drain structure 130S. The second vertical separation layer may be disposed between the plurality of sub-gates 160S, the nanosheet stack NSS, and the lower insulating layer 166 and the second source/drain structure 130D.

Vertical lengths of the first vertical separation layer and the second vertical separation layer may be different from each other. In particular, the length of the first vertical separation layer in the vertical direction may be greater than the length of the second vertical separation layer in the vertical direction. An upper end of the first vertical separation layer and an upper end of the second vertical separation layer may respectively contact a lower end of the outer insulating spacer 118. Therefore, vertical levels of the upper end of the first vertical separation layer and the upper end of the second vertical separation layer may be substantially the same. On the other hand, a vertical level of a lower end of the second vertical separation layer may be higher than a vertical level of a lower end of the first vertical separation layer.

In an embodiment, the first source/drain structure 130S may pass through the bottom dielectric isolation BDI and the lower insulating layer 166. The lower surface of the first source/drain structure 130S may contact and electrically connect to the upper surface of the lower via contact 196. The second source/drain structure 130D may not penetrate the bottom dielectric isolation BDI and the lower insulating layer 166. A lower surface of the second source/drain structure 130D may contact the bottom dielectric isolation BDI. An upper surface of the second source/drain structure 130D may contact and be electrically connected to a lower surface of the upper via contact VA. Here, the first source/drain structure 130S may function as a source and the second source/drain structure 130D may function as a drain.

Since a main gate is not provided in all gate structures 160 between the source/drain structures 130, the vertical height of the gate structure 160 including the plurality of sub-gates 160S may be the same or substantially the same as the vertical height of the gate structure 160 between the other source/drain structures 130. That is, the vertical height of the gate structure 160 between the source/drain structures 130 may be constant.

In addition to the aspects of the integrated circuit device 100, which is another embodiment described above, in the integrated circuit device 100B, which is an embodiment, the distance between the gate structure 160 and the upper via contact VA is greater than the distance between the gate structure 160 and the upper via contact VA of the integrated circuit device 100, which is another embodiment, so that the possibility of short circuiting may be reduced and/or prevented.

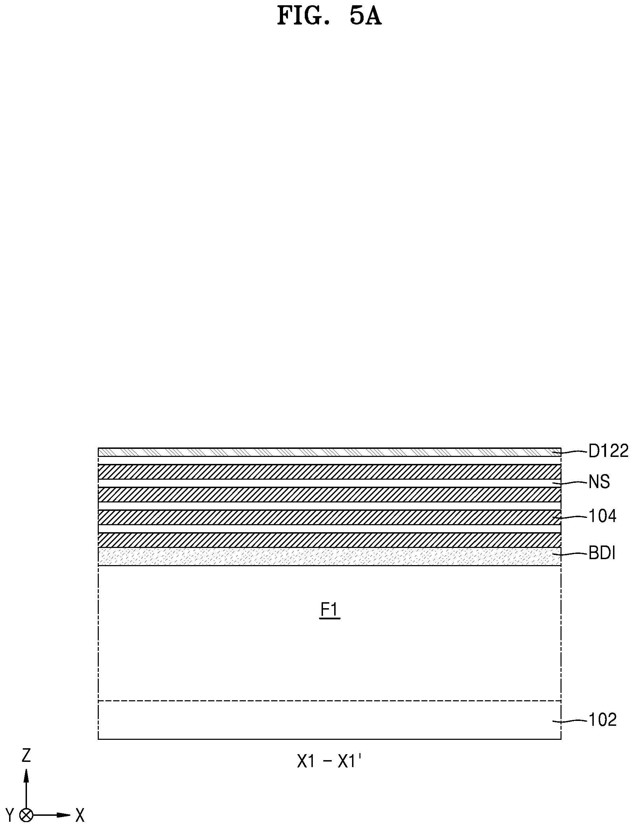

FIGS. 5A to 5G are diagrams illustrating a manufacturing method of an integrated circuit device 100, according to an embodiment.

Referring to FIG. 5A, a substrate 102 is prepared, a bottom dielectric isolation BDI is formed on the substrate 102, and a plurality of sacrificial semiconductor layers 104 and a plurality of nanosheets NS may be alternately stacked layer by layer on the bottom dielectric isolation BDI. An oxide film D122 may be formed on the uppermost nanosheet NS.

The plurality of sacrificial semiconductor layers 104 and the plurality of nanosheets NS may be formed of semiconductor materials having different etching selectivities. In example embodiments, the plurality of nanosheets NS may include a Si layer and the plurality of sacrificial semiconductor layers 104 may include a SiGe layer. In example embodiments, the Ge content in the plurality of sacrificial semiconductor layers 104 may be constant. The SiGe layer constituting the plurality of sacrificial semiconductor layers 104 may have a constant Ge content selected within a range of about 5 atomic% to about 50 atomic%, for example, about 10 atomic% to about 40 atomic %. The Ge content in the SiGe layer constituting the plurality of sacrificial semiconductor layers 104 may be variously selected as necessary.

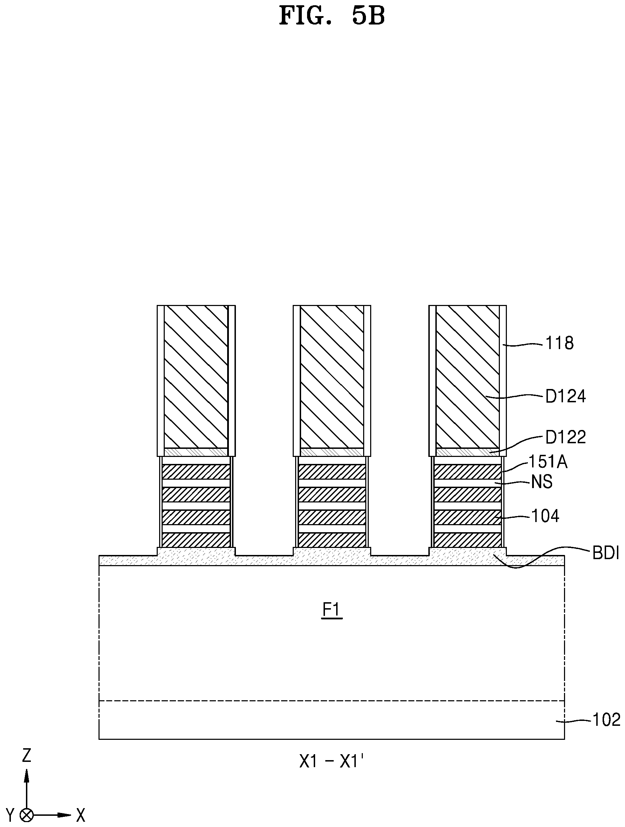

Referring to FIG. 5B, in the result of FIG. 5A, portions of each of the plurality of sacrificial semiconductor layers 104, the plurality of nanosheets NS, the oxide film D122, the bottom dielectric isolation BDI, and the substrate 102 are etched so that a plurality of fin-type active structures F1 may be formed on the substrate 102. FIG. 5B shows that a stacked structure of a plurality of sacrificial semiconductor layers 104, a plurality of nanosheets NS, and an oxide film D122 partially remains on the upper surface of the plurality of fin-type active structures F1.

An oxide film D122 and a dummy gate layer D124 may have a sequentially stacked structure that extends long in the second horizontal direction (Y direction). In example embodiments, the dummy gate layer D124 may be made of polysilicon.

After forming a plurality of outer insulating spacers 118 covering both sidewalls of the oxide film D122 and the dummy gate layer D124, by using the oxide film D122, the dummy gate layer D124, and the outer insulating spacer 118 as an etching mask, a portion of each of the plurality of sacrificial semiconductor layers 104 and the plurality of nanosheets NS may be etched. Through etching, the nanosheets NS may be divided into a plurality of nanosheet stacks, and recesses in which source/drain structures are provided may be formed between the nanosheet stacks and on the bottom dielectric isolation BDI. To form the recess, dry etching, wet etching, or a combination thereof may be used for etching. During the recess process, the bottom dielectric isolation BDI may be etched so as not to be penetrated.

A silicon separation layer 151A among vertical separation layers 151 may be epitaxially grown on side surfaces of the plurality of sacrificial semiconductor layers 104 and the plurality of nanosheets NS in the first horizontal direction. The silicon separation layer 151A may be formed by using an epitaxial growth process, such as Vapor-Phase Epitaxy (VPE), Ultra-High Vacuum CVD (UHV-CVD), or Molecular Beam Epitaxy (MBE). Since the epitaxial growth process may be selective for semiconductor materials and relatively negligible for dielectric materials, a silicon separation layer 151A formed thin by epitaxial growth may be formed on side surfaces of the plurality of sacrificial semiconductor layers 104 and the plurality of nanosheets NS in the first horizontal direction in the first horizontal direction (X direction).

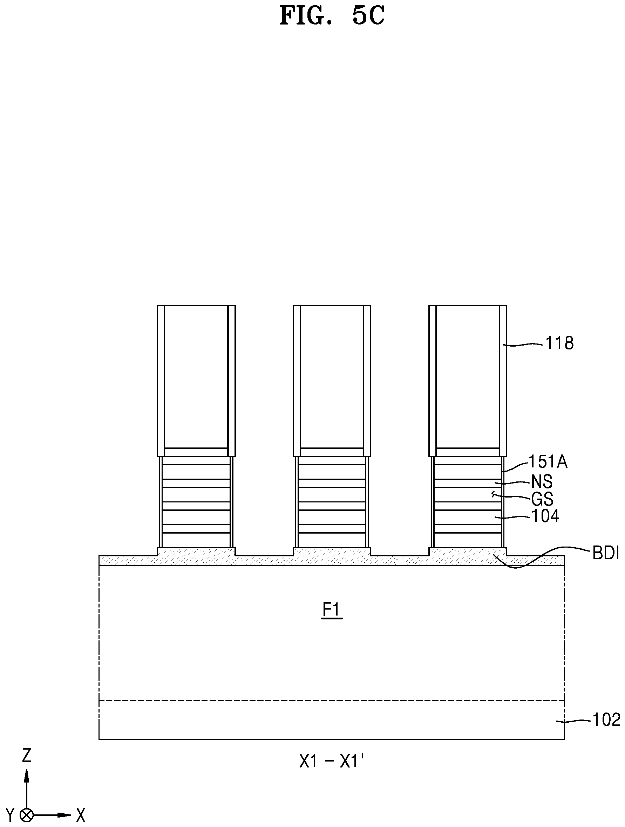

Referring to FIG. 5C, after filling the recesses between the plurality of nanosheet stacks with oxide, a gate space GS is prepared by removing the plurality of sacrificial semiconductor layers 104, the oxide film D122 thereon, and the dummy gate layer D124 from the result of FIG. 5B, and a plurality of nanosheet stacks NSS may be exposed through the gate space GS. In example embodiments, to selectively remove the plurality of sacrificial semiconductor layers 104, a difference in etching selectivity between the plurality of nanosheets NS and the plurality of sacrificial semiconductor layers 104 may be used.

A liquid or gaseous etchant may be used to selectively remove the plurality of sacrificial semiconductor layers 104. In embodiments, to selectively remove the plurality of sacrificial semiconductor layers 104, a CH₃COOH-based etchant, for example, an etchant composed of and/or including a mixture of CH₃COOH, HNO₃, and HF, or an etchant composed of and/or including a mixture of CH₃COOH, H₂O₂, and HF may be used, but is not limited to those examples above.

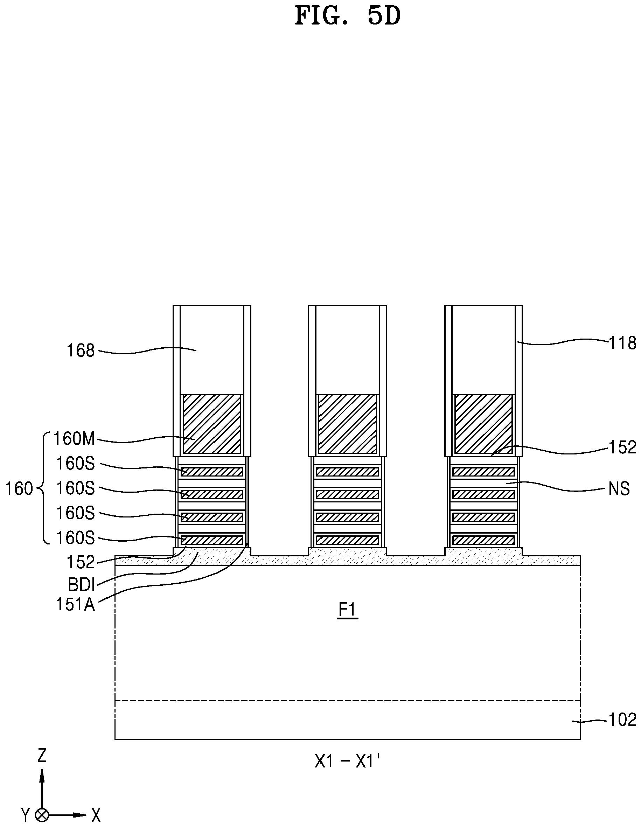

Referring to FIG. 5D, a gate dielectric film 152 covering exposed surfaces of each of the plurality of nanosheets NS and the bottom dielectric isolation BDI may be formed. An atomic layer deposition (ALD) process may be used to form the gate dielectric film 152. After that, a gate structure 160 filling a part of the gate space GS (see FIG. 5C) on the gate dielectric film 152 and a capping insulation pattern 168 covering upper surfaces of each of the gate structure 160 and the gate dielectric film 152 in the gate space GS may be formed.

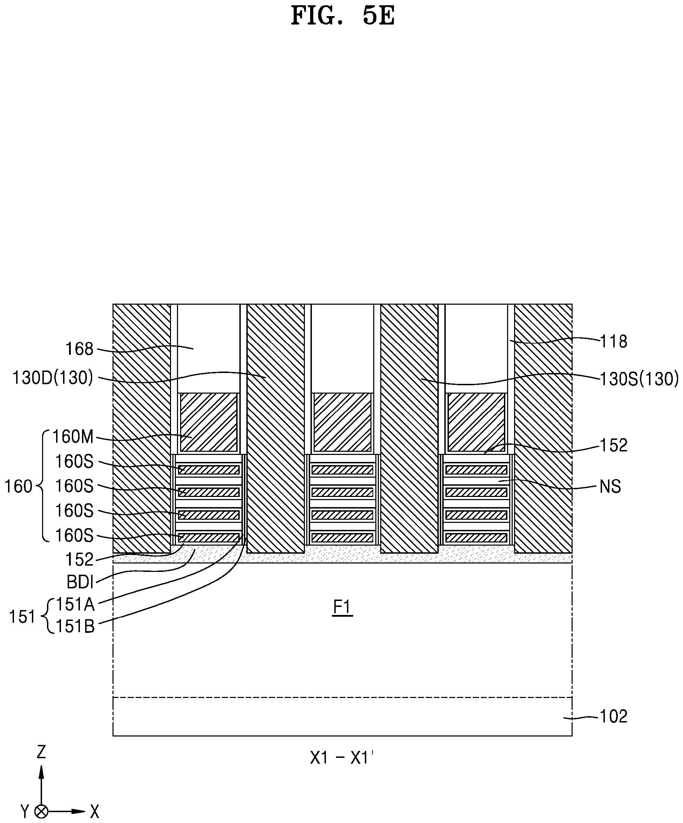

Referring to FIG. 5E, before the source/drain structures 130 are formed, a silicide separation layer 151B may be formed on a side surface of the silicon separation layer 151A. That is, the silicide separation layer 151B may be formed on a side surface of the silicon separation layer 151A with the sub-gate 160S and the silicon separation layer 151A therebetween. To avoid Schottky junction when the source/drain structure 130 including metal and the silicon separation layer 151A are in direct contact, a silicide separation layer 151B is disposed between the source/drain structure 130 and the silicon separation layer 151A. After forming a metal film on the silicon separation layer 151A, a silicide separation layer 151B may be formed through annealing. The metal film may be, for example, TiN.

A source/drain structure 130 may be formed in a recess formed between the nanosheet stack and the gate structure 160. Each of the plurality of source/drain structures 130 may be made of metal. Each of the plurality of source/drain structures 130 may contact the silicide separation layer 151B. The plurality of source/drain structures 130 may be formed using PVD, CVD or ALD. The plurality of source/drain structures 130 may be formed of a metal including at least one of Ti, W, Ru, Nb, Mo, Hf, Ni, Co, Pt, Yb, Tb, Dy, Er, and Pd.

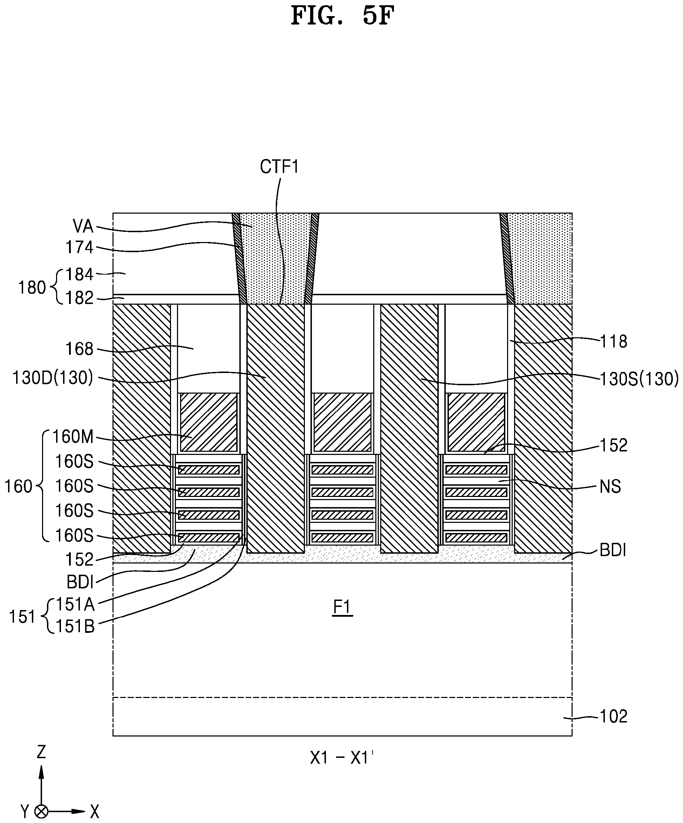

Referring to Figure 5F, in the result of FIG. 5E, an etch stop film 182 and an upper insulating film 184 are sequentially formed to cover the upper surfaces of the plurality of source/drain structures 130 and the plurality of capping insulating patterns 168, respectively, so that an upper insulating structure 180 may be formed. Thereafter, the upper via contact VA penetrates the upper insulating structure 180 in the vertical direction (Z direction) and the upper insulating liner 174 between the upper insulating structure 180 and the upper via contact VA may be formed. The upper insulating liner 174 may be formed to surround a part of the circumference of the upper via contact VA. Although not shown, an upper wiring layer may be formed on the upper surface of the upper via contact VA.

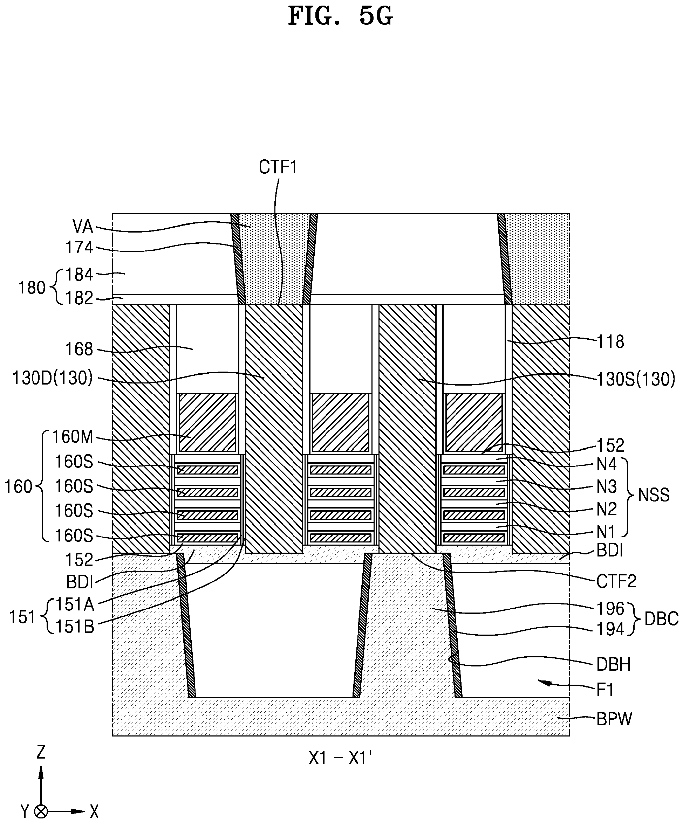

Referring to FIG. 5G, in the result of FIG. 5E, to remove the substrate 102, at least one process selected from a mechanical grinding process, a chemical mechanical polishing (CMP) process, a wet etching process, or a combination thereof may be used.

After the substrate 102 is removed, a device isolation film 112 may be formed as illustrated in FIG. 2B. A contact space DBH extending to a lower surface of a portion of the source/drain structure 130 may be formed in the device isolation film 112 through patterning. The backside source/drain contact DBC may fill the contact space DBH formed through the fin-type active structure F1. The backside source/drain contact DBC may be formed to contact a lower end of the source/drain structure 130. Through the process of FIGS. 5A to 5G described above, the integrated circuit device 100 according to an embodiment may be manufactured.

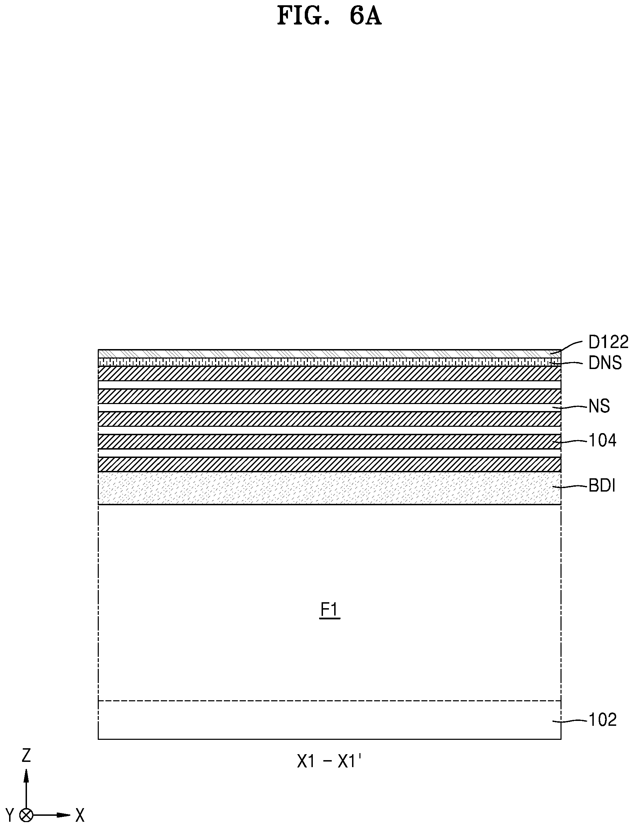

FIGS. 6A to 6G are diagrams illustrating a manufacturing method of an integrated circuit device 100A, which is an embodiment. Description within the range overlapping with the above description of FIGS. 5A to 5G may be omitted.

Referring to FIG. 6A, a substrate 102 is prepared, a bottom dielectric isolation BDI is formed on a substrate 102, and a plurality of sacrificial semiconductor layers 104 and a plurality of nanosheets NS may be alternately stacked layer by layer on the bottom dielectric isolation BDI. A dummy nanosheet DNS and an oxide film D122 may be formed on the uppermost sacrificial semiconductor layer 104 of the sacrificial semiconductor layer 104.

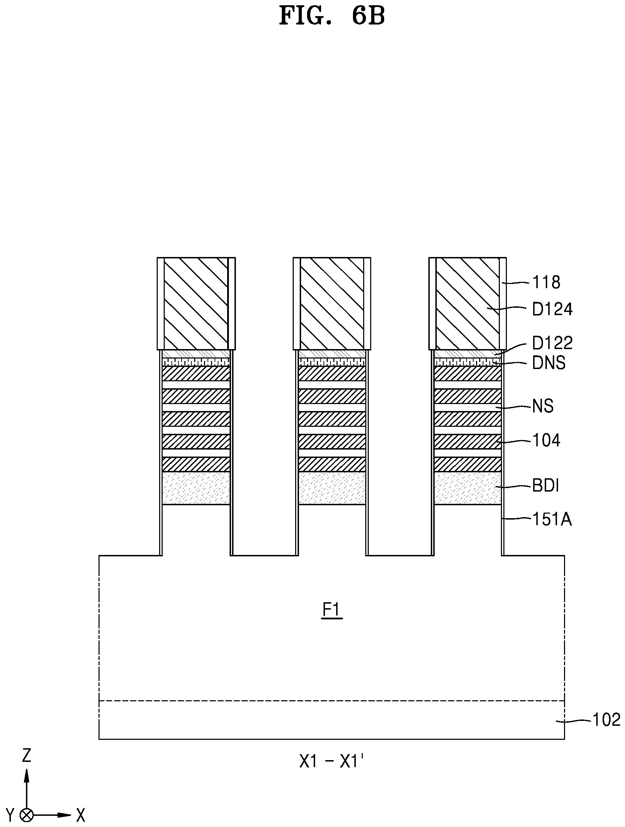

Referring to FIG. 6B, in the result of FIG. 6A, a portion of each of the plurality of sacrificial semiconductor layers 104, the plurality of nanosheets NS, the oxide film D122, the dummy nanosheet DNS, the bottom dielectric isolation BDI, and the substrate 102 is etched, so that a plurality of fin-type active structures F1 may be formed on the substrate 102. FIG. 6B shows that a stacked structure of the plurality of sacrificial semiconductor layers 104, the plurality of nanosheets NS, the dummy nanosheet DS, and the oxide film D122 partially remains on the upper surface of the plurality of fin-type active structures F1. Unlike in FIG. 5B, a recess in which a source/drain structure is formed may be formed at a vertical level lower than bottom dielectric isolation BDI.

An oxide film D122 and a dummy gate layer D124 may have a sequentially stacked structure so as to elongate in the second horizontal direction (Y direction). In example embodiments, the dummy gate layer D124 may be made of polysilicon.

After forming a plurality of outer insulating spacers 118 covering both sidewalls of the oxide film D122 and the dummy gate layer D124, a portion of each of the plurality of sacrificial semiconductor layers 104, the bottom dielectric isolation BDI, and the plurality of nanosheets NS may be etched by using the oxide film D122, the dummy gate layer D124, and the outer insulating spacer 118 as an etching mask. Through etching, the nanosheet NS may be divided into a plurality of nanosheet stacks. To form the recess, dry etching, wet etching, or a combination thereof may be used for etching. On a first horizontal side surface of a plurality of sacrificial semiconductor layers 104, a plurality of nanosheets NS, a bottom dielectric isolation BDI, and a portion of the substrate 102, a silicon separation layer 151A may be epitaxially grown.

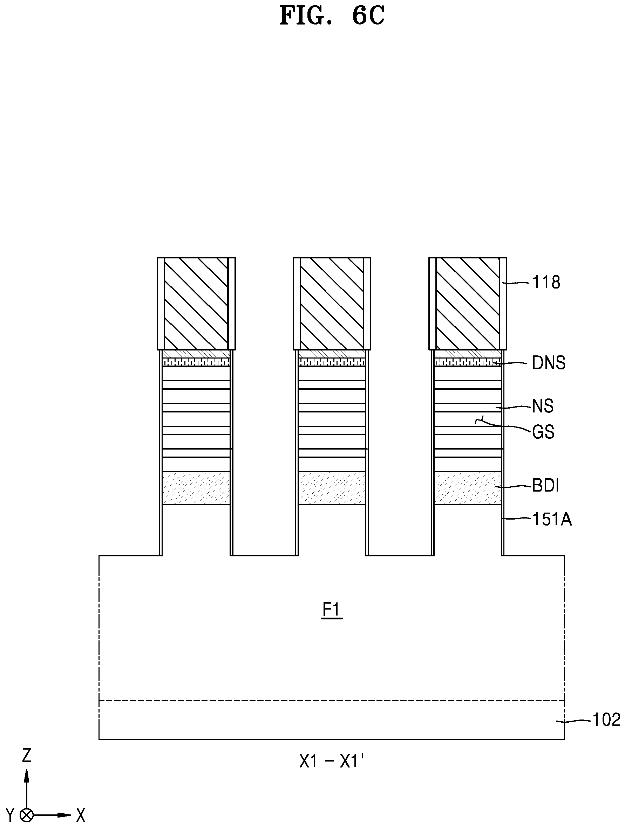

Referring to FIG. 6C, after filling the recesses between the plurality of nanosheet stacks with oxide, a gate space GS is prepared by removing the plurality of sacrificial semiconductor layers 104, the oxide film D122 thereon, and the dummy gate layer D124 from the result of FIG. 6B, and a plurality of nanosheet stacks NSS may be exposed through the gate space GS. In example embodiments, to selectively remove the plurality of sacrificial semiconductor layers 104, a difference in etching selectivity between the plurality of nanosheets NS and the plurality of sacrificial semiconductor layers 104 may be used.

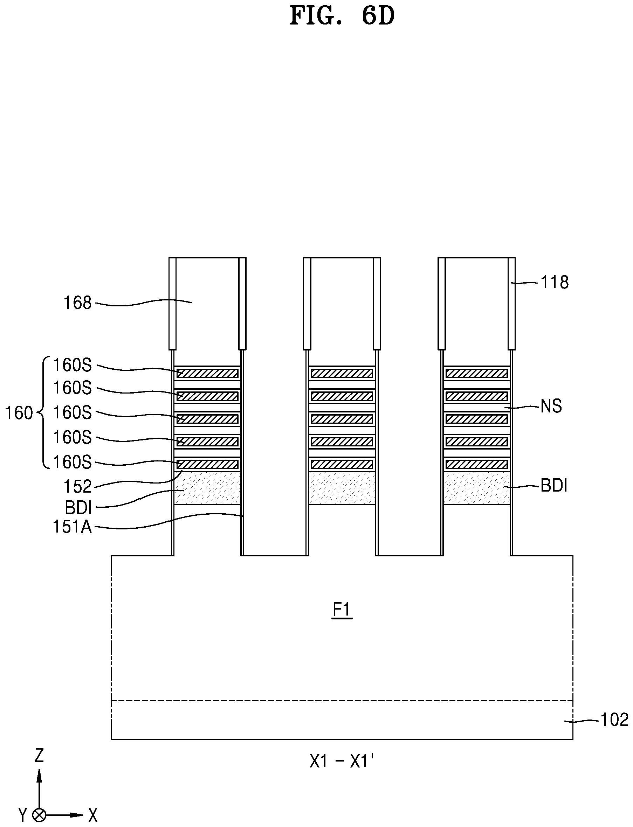

Referring to FIG. 6D, a gate dielectric film 152 covering exposed surfaces of each of the plurality of nanosheets NS and the bottom dielectric isolation BDI may be formed. An ALD process may be used to form the gate dielectric film 152. After that, a gate structure 160 filling a part of the gate space GS (see FIG. 6C) may be formed on the gate dielectric film 152. The dummy nanosheet DNS may be removed, and a capping insulating pattern 168 covering upper surfaces of each of the gate structure 160 and the gate dielectric film 152 may be formed in the gate space GS.

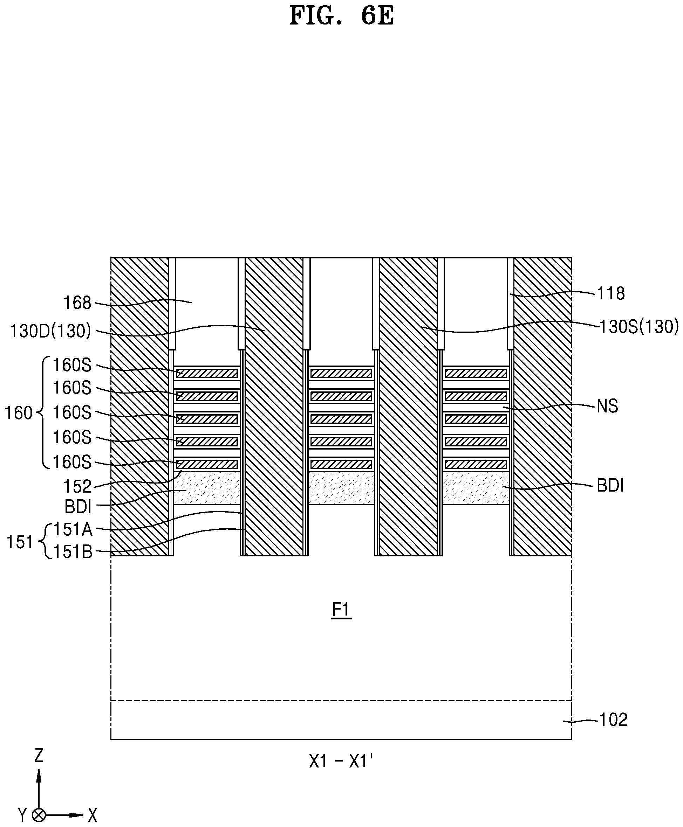

Referring to FIG. 6E, before the source/drain structures 130 are formed, a silicide separation layer 151B may be formed on a side surface of the silicon separation layer 151A. That is, the silicide separation layer 151B may be formed on a side surface of the silicon separation layer 151A with the sub-gate 160S and the silicon separation layer 151A therebetween. To avoid Schottky junction when the source/drain structure 130 including metal and the silicon separation layer 151A are in direct contact, a silicide separation layer 151B is disposed between the source/drain structure 130 and the silicon separation layer 151A. After forming a metal film on the silicon separation layer 151A, a silicide separation layer 151B may be formed through annealing. The metal film may be, for example, TiN.

After the silicide separation layer 151B is formed, a source/drain structure 130 may be formed in a recess formed between the nanosheet stack and the gate structure 160. Each of the plurality of source/drain structures 130 may be made of metal. The plurality of source/drain structures 130 may be formed using PVD, CVD or ALD. The plurality of source/drain structures 130 may be formed of a metal including at least one of Ti, W, Ru, Nb, Mo, Hf, Ni, Co, Pt, Yb, Tb, Dy, Er, and Pd.

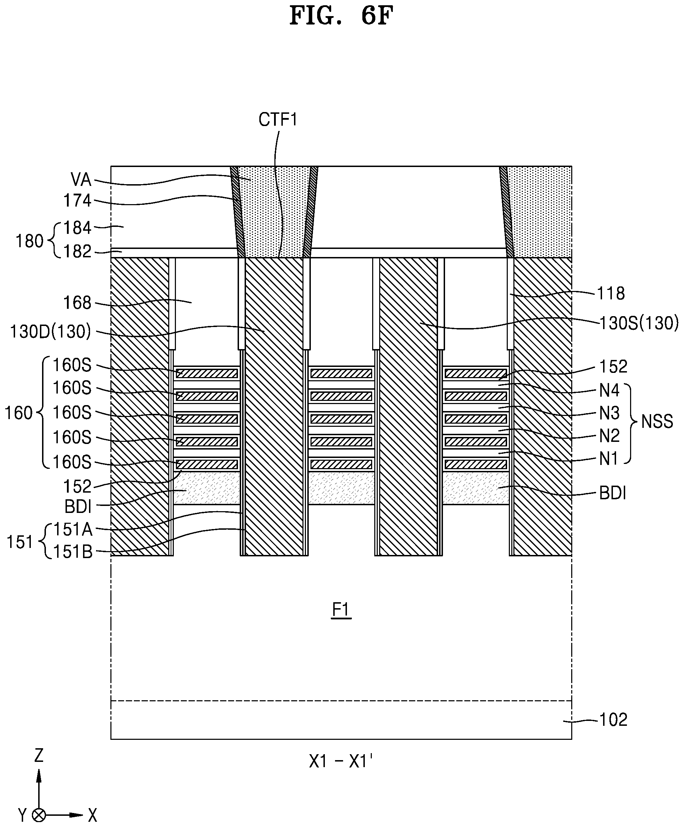

Referring to Figure 6F, in the result of FIG. 6E, an etch stop film 182 and an upper insulating film 184 are sequentially formed to cover the upper surfaces of the plurality of source/drain structures 130 and the plurality of capping insulating patterns 168, respectively, so that an upper insulating structure 180 may be formed. Thereafter, the upper via contact VA penetrates the upper insulating structure 180 in the vertical direction (Z direction) and the upper insulating liner 174 between the upper insulating structure 180 and the upper via contact VA may be formed.

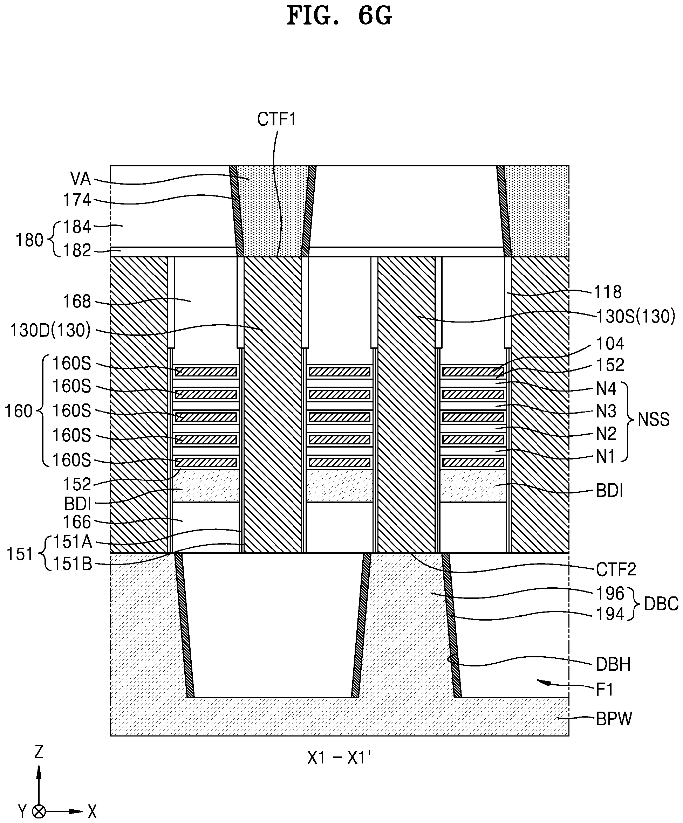

Referring to FIG. 6G, in the result of FIG. 6F, to remove the substrate 102, at least one process selected from a mechanical grinding process, a chemical mechanical polishing (CMP) process, a wet etching process, or a combination thereof may be used. A lower insulating layer 166 may be formed in a portion where the substrate 102 is removed between adjacent source/drain structures.

Then, a device isolation film 112 may be formed. A contact space DBH extending to a lower surface of a portion of the source/drain structure 130 may be formed in the device isolation film 112 through patterning as illustrated in FIG. 3B. The backside source/drain contact DBC may fill the contact space DBH formed through the fin-type active structure F1. The backside source/drain contact DBC may be formed to contact a lower end of the source/drain structure 130. Through the process of FIGS. 6A to 6G described above, an integrated circuit device 100A according to an embodiment may be manufactured. It will be understood that as a part of the recess formed between the plurality of nanosheets NS to provide the source/drain structure 130 is formed so as not to penetrate the bottom dielectric isolation BDI, the integrated circuit device 100B, which is another embodiment, may be manufactured.

While inventive concepts has been particularly shown and described with reference to embodiments thereof, it will be understood that various changes in form and details may be made therein without departing from the scope of the following claims.

### ANNEX A

The present invention can also be defined by reference to the following clauses:
Clause 1. An integrated circuit device comprising:
   a fin-type active structure elongated in a first horizontal direction;
   a nanosheet stack on an upper surface of the fin-type active structure, the nanosheet stack including a plurality of nanosheets spaced apart from the upper surface of the fin-type active structure at different vertical distances from the upper surface of the fin-type active structure;
   a gate structure on the fin-type active structure,
      the gate structure including at least one sub-gate surrounding at least one nanosheet among the plurality of nanosheets on the fin-type active structure,
      the gate structure being between each of the plurality of nanosheets and elongated in a second horizontal direction,
      the second horizontal direction crossing the first horizontal direction;
   a source/drain structure on the fin-type active structure at a position adjacent to the gate structure and the nanosheet stack in the first horizontal direction;
   a vertical separation layer including a silicide separation layer and a silicon separation layer in contact with the silicide separation layer,
      the silicide separation layer being between the source/drain structure and the nanosheet stack and between the source/drain structure and the gate structure,
      the silicide separation layer contacting the source/drain structure,
      the silicon separation layer being between the silicide separation layer and the nanosheet stack and between the silicide separation layer and the gate structure; and
   a bottom dielectric isolation under a lower surface of the gate structure, wherein
   the source/drain structure includes a material including metal.
Clause 2. The integrated circuit device of clause 1, further comprising:
   a lower via contact contacting a portion of the bottom dielectric isolation; and
   a lower power rail electrically connected to a lower portion of the lower via contact, wherein
   the source/drain structure includes a first source/drain structure and a second source/drain structure with the gate structure and the nanosheet stack therebetween, and
   the lower via contact is connected to a lower end of the first source/drain structure.
Clause 3. The integrated circuit device of clause 2, wherein
   the bottom dielectric isolation extends from under the gate structure to contact a lower surface of the second source/drain structure.
Clause 4. The integrated circuit device of any preceding clause, further comprising:
   a plurality of lower via contacts passing through portions of the bottom dielectric isolation; and
   a lower power rail electrically connected to lower portions of the plurality of lower via contacts, wherein
   the source/drain structure comprises a plurality of first source/drain structures and a plurality of second source/drain structures alternately provided in the first horizontal direction, and
   the plurality of lower via contacts contact lower surfaces of the plurality of first source/drain structures, and
   a lower power rail electrically connected to lower portions of the plurality of lower via contacts.
Clause 5. The integrated circuit device of clause 4, wherein the bottom dielectric isolation extends from under the gate structure to contact a lower surface of a corresponding second source/drain structure among the plurality of second source/drain structures.
Clause 6. The integrated circuit device of clause 5, further comprising:
   an upper via contact contacting an upper surface of the corresponding second source/drain structure.
Clause 7. The integrated circuit device of clause 6, wherein the gate structure comprises a main gate extending in the second horizontal direction on the nanosheet stack.
Clause 8. The integrated circuit device of clause 7, further comprising:
   a capping insulating pattern on the gate structure, wherein
   the capping insulating pattern is on the at least one sub-gate and the nanosheet stack.
Clause 9. The integrated circuit device of clause 8, further comprising:
   a lower insulating layer in contact with a lower surface of the bottom dielectric isolation between the plurality of first source/drain structures and the plurality of second source/drain structures, wherein
   a vertical level of a lower surface of the lower insulating layer is the same as a vertical level of the lower surfaces of the plurality of first source/drain structures and lower surfaces of the plurality of second source/drain structures,
   the vertical separation layer extends between the nanosheet stack and an adjacent one of the plurality of first source/drain structures,
   the vertical separation layer extends between the nanosheet stack and an adjacent one of the plurality of second source/drain structures,
   the vertical separation layer extends between the gate structure and the adjacent one of the plurality of first source/drain structures,
   the vertical separation layer extends between the gate structure and the adjacent one of the plurality of second source/drain structures,
   the vertical separation layer is between lower insulating layer and the plurality of first source/drain structures, and
   the vertical separation layer is between lower insulating layer and the plurality of second source/drain structures.
Clause 10. The integrated circuit device of clause 9, wherein
   a vertical level of a lower surface of the vertical separation layer is the same as the vertical level of the lower surfaces of the plurality of first source/drain structures and the lower surfaces of the plurality of second source/drain structures, and
   a vertical level of an upper surface of the vertical separation layer is higher than a vertical level of an upper surface of the nanosheet stack.
Clause 11. The integrated circuit device of clause 10, wherein
   a first contact surface is where the upper via contacts the upper surface of the corresponding second source/drain structure,
   a second contact surface where one of the plurality of lower vias contacts the lower surface of one of the plurality of the first source/drain structures,
   a difference between a vertical level of the first contact surface and a vertical level of the second contact surface is equal to vertical lengths of the plurality of first source/drain structures and equal to vertical lengths of the plurality of second source/drain structures.
Clause 12. The integrated circuit device of any preceding clause, wherein
   the silicide separation layer includes one of phosphorus (P), arsenic (As), boron (B), and aluminum (Al),
   the silicide separation layer includes at least one of titanium silicide, nickel silicide, cobalt silicide, tantalum silicide, tungsten silicide, titanium gallide, nickel gallide, cobalt gallide, tantalum gallide, and tungsten gallide, and
   the silicon separation layer includes at least one of metal silicide, metal germanide, metal gallide, and metal aluminide.
Clause 13. The integrated circuit device of any preceding clause, wherein the source/drain structure includes at least one of Ti, W, Ru, Nb, Mo, Hf, Ni, Co, Pt, Yb, Tb, Dy, Er, and Pd.
Clause 14. An integrated circuit device comprising:
   a fin-type active structure elongated in a first horizontal direction;
   a nanosheet stack on an upper surface of the fin-type active structure, the nanosheet stack including a plurality of nanosheets spaced apart from the upper surface of the fin-type active structure at different vertical distances from the upper surface of the fin-type active structure;
   a gate structure on the fin-type active structure,
      the gate structure including at least one sub-gate surrounding at least one nanosheet among the plurality of nanosheets on the fin-type active structure,
   the gate structure being between each of the plurality of nanosheets and elongated in a second horizontal direction,
   the second horizontal direction crossing the first horizontal direction;
   a source/drain structure including a first source/drain structure and a second source/drain structure on the fin-type active structure respectively at positions adjacent to the gate structure, the first source/drain structure and the second source/drain structure facing the nanosheet stack in the first horizontal direction, and the first source/drain structure and the second source/drain structure being among a plurality of first source/drain structures and a plurality of second source/drain structures provided alternately in the first horizontal direction on the fin-type active structure;
      a vertical separation layer including a silicide separation layer and a silicon separation layer in contact with the silicide separation layer,
      the vertical separation layer including a first vertical separation layer between the first source/drain structure and each of the nanosheet stack and the gate structure,
      the vertical separation layer including a second vertical separation layer between the second source/drain structure and each of the nanosheet stack and the gate structure, the silicide separation layer of the first vertical separation layer contacting the first source/drain structure and the silicide separation layer of the second vertical separation layer contacting the second source/drain structure,
   the silicon separation layer of the first vertical separation layer being between the silicide separation layer of the first vertical separation layer and each of the nanosheet stack and the gate structure, and
      the silicon separation layer of the second vertical separation layer being between the silicide separation layer of the second vertical separation layer and each of the nanosheet stack and the gate structure; and
   a bottom dielectric isolation in contact with a lower surface of the gate structure, wherein
   the first source/drain structure and the second source/drain structure of the source/drain structure each include a material including metal.
Clause 15. The integrated circuit device of clause 14, wherein
   the first source/drain structure extends through the bottom dielectric isolation, and a lower surface of the second source/drain structure contacts the bottom dielectric isolation.

## Claims

1. An integrated circuit device comprising:
a fin-type active structure elongated in a first horizontal direction;
a nanosheet stack on an upper surface of the fin-type active structure, the nanosheet stack including a plurality of nanosheets spaced apart from the upper surface of the fin-type active structure at different vertical distances from the upper surface of the fin-type active structure;
a gate structure on the fin-type active structure,
the gate structure including at least one sub-gate surrounding at least one nanosheet among the plurality of nanosheets on the fin-type active structure,
the gate structure being between each of the plurality of nanosheets and elongated in a second horizontal direction,
the second horizontal direction crossing the first horizontal direction;
a source/drain structure on the fin-type active structure at a position adjacent to the gate structure and the nanosheet stack in the first horizontal direction;
a vertical separation layer including a silicide separation layer and a silicon separation layer in contact with the silicide separation layer,
the silicide separation layer being between the source/drain structure and the nanosheet stack and between the source/drain structure and the gate structure,
the silicide separation layer contacting the source/drain structure,
the silicon separation layer being between the silicide separation layer and the nanosheet stack and between the silicide separation layer and the gate structure; and
a bottom dielectric isolation under a lower surface of the gate structure, wherein
the source/drain structure includes a material including metal.

2. The integrated circuit device of claim 1, further comprising:
a lower via contact contacting a portion of the bottom dielectric isolation; and
a lower power rail electrically connected to a lower portion of the lower via contact, wherein:
the source/drain structure includes a first source/drain structure and a second source/drain structure with the gate structure and the nanosheet stack therebetween, and
the lower via contact is connected to a lower end of the first source/drain structure.

3. The integrated circuit device of claim 2, wherein
the bottom dielectric isolation extends from under the gate structure to contact a lower surface of the second source/drain structure.

4. The integrated circuit device of any preceding claim, further comprising:
a plurality of lower via contacts passing through portions of the bottom dielectric isolation; and
a lower power rail electrically connected to lower portions of the plurality of lower via contacts, wherein
the source/drain structure comprises a plurality of first source/drain structures and a plurality of second source/drain structures alternately provided in the first horizontal direction,
the plurality of lower via contacts contact lower surfaces of the plurality of first source/drain structures, and
a lower power rail electrically connected to lower portions of the plurality of lower via contacts.

5. The integrated circuit device of claim 4, wherein the bottom dielectric isolation extends from under the gate structure to contact a lower surface of a corresponding second source/drain structure among the plurality of second source/drain structures.

6. The integrated circuit device of claim 5, further comprising:
an upper via contact contacting an upper surface of the corresponding second source/drain structure.

7. The integrated circuit device of any preceding claim, wherein the gate structure comprises a main gate extending in the second horizontal direction on the nanosheet stack.

8. The integrated circuit device of claim 1, wherein the source/drain structure comprises a plurality of first source/drain structures and a plurality of second source/drain structures alternately provided in the first horizontal direction, wherein the vertical separation layer is a first vertical separation layer, the integrated circuit device comprising:
a lower insulating layer in contact with a lower surface of the bottom dielectric isolation between the plurality of first source/drain structures and the plurality of second source/drain structures; and
a plurality of vertical separation layers including the first vertical separation layer, wherein:
a vertical level of a lower surface of the lower insulating layer is the same as a vertical level of lower surfaces of the plurality of first source/drain structures and lower surfaces of the plurality of second source/drain structures,
the first vertical separation layer extends between the nanosheet stack and an adjacent one of the plurality of first source/drain structures,
a second vertical separation layer of the plurality of vertical separation layers extends between the nanosheet stack and an adjacent one of the plurality of second source/drain structures,
the first vertical separation layer extends between the gate structure and the adjacent one of the plurality of first source/drain structures,
the second vertical separation layer extends between the gate structure and the adjacent one of the plurality of second source/drain structures,
the first vertical separation layer extends between part of the lower insulating layer and the adjacent one of the plurality of first source/drain structures, and
the second vertical separation layer extends between the part of the lower insulating layer and the adjacent one of the plurality of second source/drain structures.

9. The integrated circuit device of claim 8, wherein
a vertical level of a lower surface of each vertical separation layer is the same as the vertical level of the lower surfaces of the plurality of first source/drain structures and the lower surfaces of the plurality of second source/drain structures, and
a vertical level of an upper surface of the vertical separation layer is higher than a vertical level of an upper surface of the nanosheet stack.

10. The integrated circuit device of any preceding claim, wherein the source/drain structure comprises a plurality of first source/drain structures and a plurality of second source/drain structures alternately provided in the first horizontal direction, the integrated circuit device further comprising:
an upper via contact contacting the upper surface of a corresponding one of the second source/drain structures; and
a plurality of lower via contacts, one of the plurality of lower via contacts contacting the lower surface of one of the plurality of the first source/drain structures, wherein: a first contact surface is where the upper via contact contacts the upper surface of the corresponding one of the second source/drain structures,
a second contact surface is where the one of the plurality of lower via contacts contacts the lower surface of the one of the plurality of the first source/drain structures,
a difference between a vertical level of the first contact surface and a vertical level of the second contact surface is equal to vertical lengths of the plurality of first source/drain structures and equal to vertical lengths of the plurality of second source/drain structures.

11. The integrated circuit device of any preceding claim, further comprising a capping insulating pattern on the gate structure.

12. The integrated circuit device of any preceding claim, wherein
the silicide separation layer includes one of phosphorus (P), arsenic (As), boron (B), and aluminum (Al),
the silicide separation layer includes at least one of titanium silicide, nickel silicide, cobalt silicide, tantalum silicide, tungsten silicide, titanium gallide, nickel gallide, cobalt gallide, tantalum gallide, and tungsten gallide, and
the silicon separation layer includes at least one of metal silicide, metal germanide, metal gallide, and metal aluminide.

13. The integrated circuit device of any preceding claim, wherein the source/drain structure includes at least one of Ti, W, Ru, Nb, Mo, Hf, Ni, Co, Pt, Yb, Tb, Dy, Er, and Pd.

14. An integrated circuit device as claimed in any preceding claim, wherein:
the source/drain structure includes a first source/drain structure and a second source/drain structure on the fin-type active structure respectively at positions adjacent to the gate structure, the first source/drain structure and the second source/drain structure facing the nanosheet stack in the first horizontal direction, and the first source/drain structure and the second source/drain structure being among a plurality of first source/drain structures and a plurality of second source/drain structures provided alternately in the first horizontal direction on the fin-type active structure, wherein:
the vertical separation layer includes a first vertical separation layer between the first source/drain structure and each of the nanosheet stack and the gate structure,
the vertical separation layer includes a second vertical separation layer between the second source/drain structure and each of the nanosheet stack and the gate structure,
the silicide separation layer of the first vertical separation layer is in contact with the first source/drain structure and the silicide separation layer of the second vertical separation layer, the second vertical separation layer being in contact with the second source/drain structure,
the silicon separation layer of the first vertical separation layer being between the silicide separation layer of the first vertical separation layer and each of the nanosheet stack and the gate structure, and
the silicon separation layer of the second vertical separation layer being between the silicide separation layer of the second vertical separation layer and each of the nanosheet stack and the gate structure; and
the first source/drain structure and the second source/drain structure of the source/drain structure each include the material including metal.

15. The integrated circuit device of claim 14, wherein
the first source/drain structure extends through the bottom dielectric isolation, and
a lower surface of the second source/drain structure is in contact with the bottom dielectric isolation.
